Europäisches Patentamt

European Patent Office

Office européen des brevets

(11) Publication number: **0 180 054**
A2

(12) **EUROPEAN PATENT APPLICATION**

(21) Application number: 85112541.9

(22) Date of filing: 03.10.85

(51) Int. Cl.⁴: **G 11 C 7/00, G 11 C 11/40**

(30) Priority: 31.10.84 US 666851

(43) Date of publication of application: 07.05.86
**Bulletin 86/19**

(84) Designated Contracting States: **DE FR GB**

(71) Applicant: **TEXAS INSTRUMENTS INCORPORATED,**
**13500 North Central Expressway, Dallas**
**Texas 75265 (US)**

(72) Inventor: **Shah, Ashwin, 10114 Desert Willow Drive,**
**Dallas, Texas 75243 (US)**
Inventor: **Womack, Richard R., 1616 Mapleton, Dallas,**
**Texas 75223 (US)**

(74) Representative: **Leiser, Gottfried, Dipl.-Ing. et al,**
**Patentanwälte Prinz, Leiser, Bunke & Partner**
**Ernsberger Strasse 19, D-8000 München 60 (DE)**

(54) **Dual ended adaptive folded bitline scheme.**

(57) A scheme for addressing memory cells in random access memory arrays includes bitlines (BL1, BL2) divided into a plurality of segments. Each pair of bitlines (BL1, BL2) has a sense amp at each end coupled to both bitlines in the pair. Word lines (WL) address memory cells (53, 55) coupled to each bitline of the pair. When a pair of memory cells (53, 55) is accessed, the bitlines (BL1, BL2) are electrically divided so that one memory cell (53) is coupled to one sense amp (1) through one bitline (BL1) and the other memory cell (55) is coupled to the other sense amp (2) through the other bitline (BL2). The memory cells (53, 55) can be coupled to the bitlines through segment lines (52) with each segment line (52) connecting to a subset of the memory cells to a bitline (BL1, BL2) in order to reduce capacitances presented to the sense amps. An alternating linear array of sense amps and bitline pairs can be used to increase overall density of the memory array by allowing sense amps to access more than one bitline pair. The bitlines are addressed so that each sense amp recieves data from only one bitline pari at a time.

DUAL ENDED ADAPTIVE FOLDED BITLINE SCHEME

BACKGROUND AND SUMMARY OF THE INVENTION

The present invention relates to improved layout and operating schemes for integrated circuit dynamic random access memories.

In the design of sense amplifiers for dynamic random access memories (DRAMs), a common technique referred to as folded bitlines is used to increase the signal to noise ratio. In that scheme, the small voltage to be sensed is developed between two parallel bitlines. The purpose behind such scheme is to minimize any differential signal presented to the sense amps by noise or process variations. By laying the bitlines close together and matching them geometrically, most noise will be seen by the sense amp as a common mode signal. Since the sense amps are designed to detect differential voltages, such common mode noise signals do not affect the reading of data.

A key circumstance which allows the implementation of such a folded bit line approach is the ability to run two word lines within one memory cell pitch. Only one memory cell's charge can be sensed on a single bit line. The two parallel bitlines are each generally considered to be half of a bitline, and only one bit of data can be sensed per whole bitline. Because the bitline is folded into two parallel half bitlines, adjacent cells on the separate halves of a bitline must be addressed by separate word lines. Such an

0180054

- 2 -

addressing scheme is shown in Figure I. If the memory cell size is shrunk below twice the word line pitch, either the folded bit line scheme cannot be used or unused blank area must be left within the memory cell array.

It is therefore an object of the present invention to provide an improved layout and signal connection scheme whereby differential sensing such as found in folded bitlines can be used with small memory cells. It is another object of the present invention to improve the packing density of large arrays of small memory cells.

Therefore, in accordance with the present invention, two parallel bitlines have differential sense amplifiers on both ends. Adjacent memory cells on the parallel bitlines are addressed by a single word line. Both bitlines are electrically broken by pass transistors, so that one bitline couples one memory cell to one sense amp, and the other bitline couples the other memory cell to the other sense amp. Using this scheme, two bits are accessed by a single word line. In order to decrease undesirable capacitances, memory cells may be grouped into segments which are selectively coupled to the bitlines. Only the segment containing the selected memory cell is coupled to the bitline when that cell is read, so that only the capacitance of one segment line plus the bit line is presented to the sense amplifier. A repetitive linear pattern of bitlines and sense amps allows each sense amp to detect signals from bit lines on either side, although not simultaneously.

The novel features which characterize the present invention are defined by the appended claims. The foregoing and other objects and advantages of the present invention will hereinafter appear, and for purposes of illustration, but not of limitation, several preferred embodiments are shown in the accompanying drawings.

BRIEF DESCRIPTION OF THE DRAWINGS

Figure 1 shows a portion of a dynamic RAM array using a prior art folded bitline scheme;

Figure 2 shows a portion of a dynamic RAM array using a folded bitline scheme and smaller memory cells;

Figure 3 is a partial schematic diagram of a dual ended adaptive folded bitline scheme according to the present invention;

Figure 4 is a portion of a dynamic RAM array illustrating segment addressing in conjunction with a dual ended adaptive folded bitline scheme;

Figure 5 is a partial schematic diagram of a dynamic RAM array in accordance with the present invention;

Figure 6 is a block diagram illustrating an extended dynamic RAM array in accordance with the present invention.

0180054

- 5 -

DESCRIPTION OF THE PREFERRED EMBODIMENTS

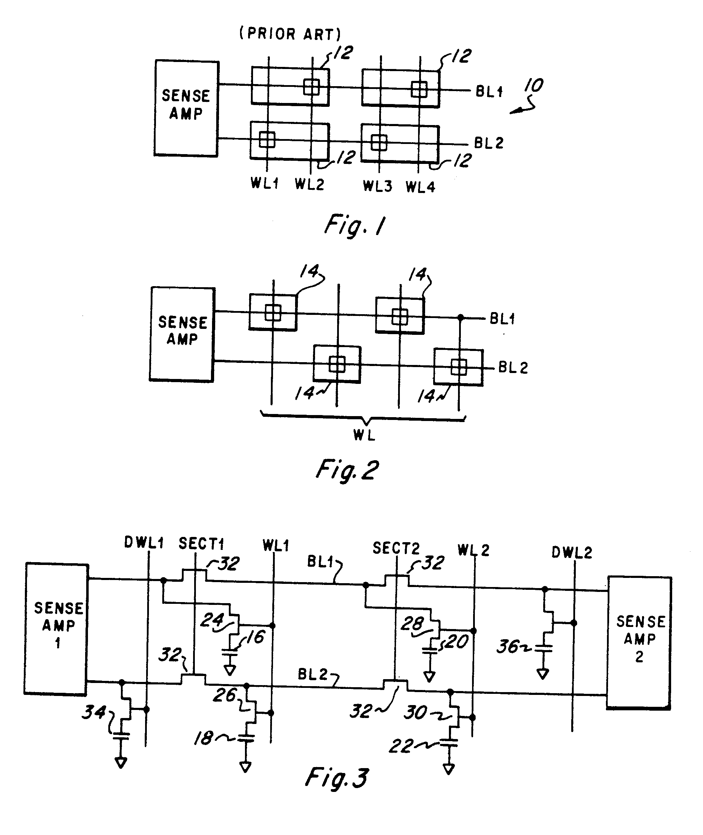

Referring to Figure 1, a small portion of a dynamic random access memory (DRAM) array 10 is shown. Figure 1 illustrates a prior art folded bitline sensing approach, utilizing a sense amplifier coupled to two parallel rows of memory cells 12. As shown, memory cells 12 are large enough that two word lines WL1,WL2,WL3,WL4 may be laid down above each cell 12. Alternate word lines WL1,WL2,WL3,WL4 will only make connection with the cells in the upper or lower rows. Here, the first and third word lines WL1, WL3 are coupled with the lower bitline BL2, and the second and fourth word lines WL2,WL4 are contacted with the upper bitline BL1. Only one word line will be activated at a time, so that a signal appears on the lower or upper bitline, but not both simultaneously. A similar arrangement would have the memory cells 12 running lengthwise under the word lines instead of the bit lines, but the packing density and operation would be basically identical.

Referring to Figure 2, a folded bitline sense amp again addresses two parallel bitlines BL1,BL2. Each bitline BL1,BL2 is connectable to a memory cell 14 with a single word line WL. In Figure 2, the surface area of each memory cell 14 is much smaller than that of the cells 12 shown in Figure 1. Such smaller surface area can be achieved by any of several techniques known in the art, and this small cell size

0180054

- 6 -

would be typical of those found on high density DRAM's, such as those having a capacity of greater than one megabit per chip. It will be seen in Figure 2 that approximately one-half of the surface area available for the cell array is wasted because of minimum spacing restrictions on both the word lines WL and bit lines BL1, BL2.

Referring to Figure 3, a technique for addressing memory cells which allows increased array density is shown. This technique uses parallel first and second bitlines BL1,BL2 having a sense amp at each end. In this scheme, a single word line WL1,WL2 addresses two adjacent memory cells 16,18,20,22 which are coupled to different bitlines. In the drawing of Figure 2, this would mean that four additional memory cells could be interspersed in that portion of the array which is shown. In this manner, no further reduction is required of the spacing between adjacent word lines WL and bitlines BL. The schematic of Figure 3 shows a DRAM array having only four cells 16,18,20,22, which are addressed in pairs by WL1 and WL2. Between the connections of the various cell select transistors 24,26,28,30 and the bitlines, section select gates 32 divide each bitline into sections. A dummy cell 34, 36 is attached to each bitline, and the two cells shown are addressed by dummy word lines DWL1 and DWL2.

The word line WL1, WL2 and dummy word line DWL1, DWL2 signals are normally low, so that no memory cells are selected. The first and second section select signals SECT 1, SECT 2 are normally high, so that each bitline is a complete low impedance path between sense amps 1 and 2. When it is desired to address a pair of memory cells, the appropriate word line signal WL goes high, and a section select signal SECT goes low. This has the effect of dividing each bitline into two parts. One bitline, in this case BL2, will couple the selected memory cell to sense amp No.2, while BL1 will couple the selected memory cell to sense amp No. 1. The effect is as if two separate folded bit line groupings and sense amps were present.

For example, assume that memory cells 16 and 18 are to be addressed. WL1 goes high, and the signal SECT 1 goes low. This couples memory cell 16 to sense amp 1, with memory cell 18 being connected to sense amp 2. Both dummy word lines DWL1,2 are also driven high, so that the respective dummy cells 34,36 are connected to the appropriate bitlines BL2,BL1. In this example, sense amp 1 will sense the value stored in memory cell 16 by comparing it with the reference charge in dummy cell 34, while sense amp 2 will read the value from memory cell 18 by comparing with the reference charge stored on dummy cell 36.

In order to sense the data in memory cells 20 and 22, SECT2 would go low, while SECT1 would remain high. All section select signals are normally high, with one signal going low in order to break both bitlines at that point and send one bit of information to each sense amp. WL2 would go high to select memory cells 20 and 22.

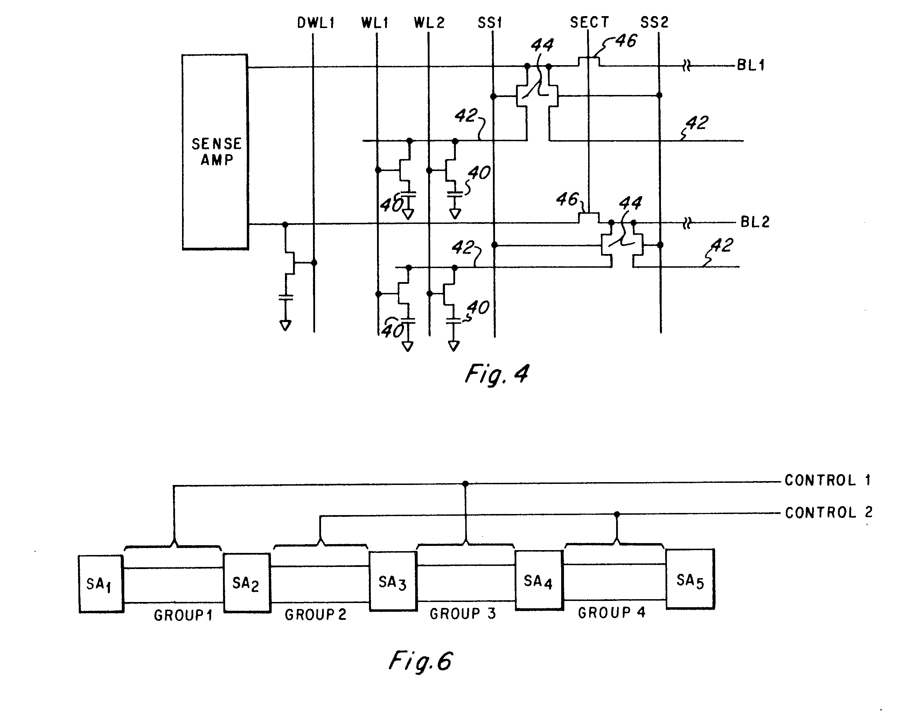

Referring to Figure 4, an interconnect scheme for grouping memory cells 46 into segments is shown. Instead of coupling each memory cell 40 directly to a bitline BL1, BL2, the memory cells are preferably coupled to segment lines 42, with each segment 42 being coupled to the bitline BL1 or BL2 through segment select transistors 44. This allows the memory cells 40 to be coupled to diffused segment lines 42, which increases packing density, while the bitlines themselves BL1, BL2 are metal, which decreases bitline capacitance. This decreases the overall capacitance encountered when sensing a selected cell 40 and allows use of a smaller number of section select transistors 46. The signals necessary to couple a given memory cell 40 to the appropriate sense amp include the word line select signals WL1 or WL2, the appropriate segment select signal SS1 or SS2, and the appropriate section select signal SECT. In addition, a dummy word line DWL must be selected to give a reference voltage for the sense amp.

In the preferred embodiment, 64 memory cells 40 are coupled to each segment line 42, with two segment lines 42 being coupled to the bit line at a single node on the appropriate side of the segment select transistor 46.

Alternatively, 4 or more segment lines 42 could be coupled together, which would require an equal number of segment select (SS) lines.

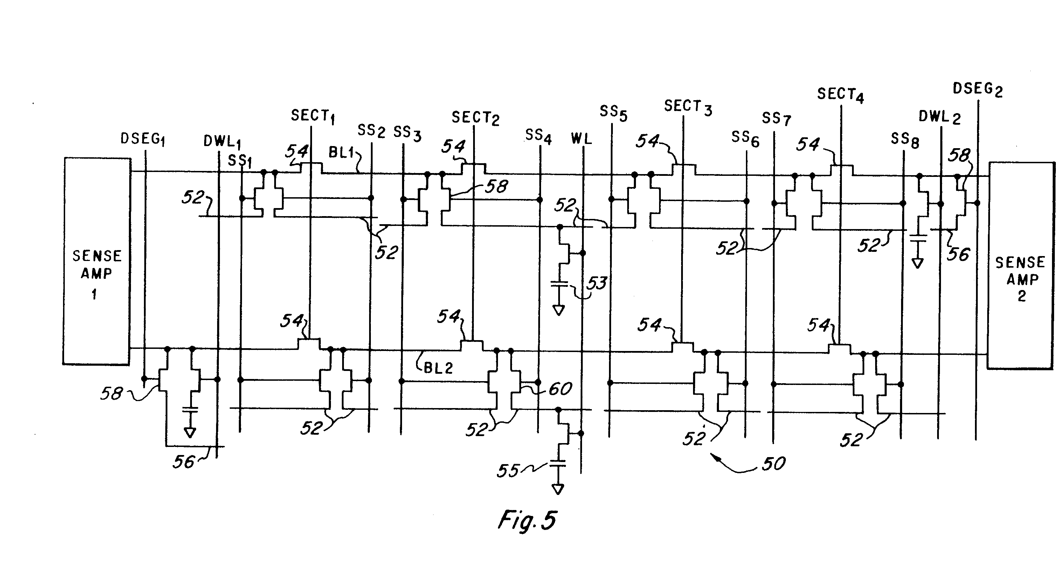

Referring to Figure 5, a preferred layout scheme for a large memory array 50 is shown in accordance with the above-described techniques. Eight segment lines 52, each containing 64 memory cells 53,55, are coupled to each bitline BL1,BL2. Segment lines 52 are coupled in pairs to single nodes on the bitline BL1,BL2, so that four section select transistors 54 are needed to divide each bitline as described above. 512 memory cells 53,55 are therefore coupled to each bitline BL1,2 , giving 1024 bits of memory in the array between two sense amps.

If it is desired that the sense amps be completely balanced, dummy segments 56 may be coupled to each bitline BL1,2 through a dummy segment select transistor 58. These dummy segments 56 do not hold information, but will have a capacitance equal to that of any selected segment 52 which is coupled to the bitline BL1,2. With basically identical capacitances coupled to each side of each sense amp, the logical value of a selected memory cell 53,55 can be sensed with an improved signal to noise ratio, resulting in greater reliability and increased tolerance to supply voltage variations. However, the use of dummy segments 56 results in a substantial area penalty, which may not be desirable. The use of such dummy segments 56 may not be required in all implementations.

In order to read data, at least four signals must change state. As shown in Figure 5, these include the word line select WL, which selects the individual memory cells 53,55 to be read, the appropriate segment select signal SS, which is SS4 for shown memory cells 53, 55, the appropriate section select signal SECT, which for the example shown is SECT2, and both dummy word line signals DWL1,DWL2. Dummy segment select signals DSEG1, DSEG2 must also be activated if dummy segments 56 are included. Except for the section select signals SECT, all signals are normally low and go high when selected. The section select signals SECT are normally high, and go low in order to turn off the selected section transistor 54. Note that this is the case for n-channel transistors; if p-channel section select transistors 54 are used, the section select signals are normally low and go high when selected. Alternatively, a CMOS pass gate could be used in place of the section select transistors 54.

When SECT2 goes low, both bitlines BL1, BL2 are divided into two pieces, with one piece of each bit line carrying the data signal to one sense amp, and the other piece serving as a reference bit line for the other, differential, sense amp. The signal from memory cell 53 being coupled through segment select transistor 58 and a portion of BL1 to sense amp 1.

Memory cell 55 is coupled to the BL2 through segment select transistor 60, and then to sense amp 2. Thus, two data bits are read by selecting a single word line WL, with an output being available at each sense amp.

The layout scheme of Figure 5 results in nearly a twofold packing density increase within the data array 50. However, two sense amps incur an area penalty on the integrated circuit chip as opposed to a single sense amp. In order to minimize such area penalty while retaining the benefits of the scheme described above, a preferred chip layout is shown in Figure 6. As will be described, this layout allows four out of five sense amps to be active simultaneously, thus decreasing the penalty incurred by use of sense amps at both ends of each bitline.

Referring to Figure 6, the pattern of Figure 5 is repeated four times, with the three interior sense amps having inputs on both sides. The word lines, segment select lines and section select lines, together identified as CONTROL1 and CONTROL2 are routed through the array so that each sense amp will only be sensing a signal on one side at a time. Thus, the memory cells of group 1 and group 3 are driven by common signals CONTROL1, and the memory cells of group 2 and group 4 are driven by signals control 2. When group one and group three are selected, SA1 and SA2 each detect one bit from group 1, as described in connection with Figure 5, with SA3 and SA4 each detecting one bit from group three. SA5 is idle. All word line and segment select signals in Control 2 are low, so that no transistors in group 2 or group 4 are activated. The section select signals closest to the sense amps are also low, so that the bit lines in the deselected group is disconnected. Therefore, no signal is presented to SA2 or SA3 from the memory cells in group two, and no signal is presented to SA4 from the memory cells in group four.

A similar situation is encountered when group two and group four are selected, with all signals CONTROL1 being as described above for CONTROL2. This causes bits to be sensed from group two by SA2 and SA3, and two bits to be sensed from group four by SA4 and SA5. SA1 is idle.

It will be seen that the scheme described above allows sensing of four bits simulanteously out of a 1024 bit array, and allows the sense amps to be used more efficiently.

The present invention has been illustrated by the methods and structures described above, and it will become apparent to those skilled in the art that various modifications and alterations may be made thereto. Such variations fall within the ambit of the present invention, the scope of which is defined by the appended claims.

0180054

- 13 -

WHAT IS CLAIMED IS:

1. A layout scheme for a dynamic random access memory, comprising:

first and second bit lines each having a plurality of sections;

first and second sense amps each coupled to adjacent ends of said first and second bit lines;

a first plurality of memory cells in a regular array, wherein said first memory cells are coupled to said first bit line;

a second plurality of memory cells in a regular array, wherein said second memory cells are coupled to said second bit line;

a plurality of word lines coupled to said first and second plurality of memory cells, wherein each of said word lines addresses a memory cell from each of said first and second pluralities of memory cells;

means for electrically breaking said first and second bit lines between selected sections, wherein addressed first memory cells are coupled to said first sense amp, and wherein addressed second memory cells are coupled to said second sense amp.

2. The memory of Claim 1, wherein said breaking means comprises:

a plurality of pass transistors in said first and second bit lines, wherein said transistors block electrical signals along said bit lines upon receipt of a section select signal;

- 14 -

means for supplying section select signals to one pass transistor in each of said bitlines, wherein the pass transistors so selected lie between the addressed first memory cells and said second sense amp, and between addressed second memory cells and said first sense amp.

3. The memory of Claim 2, wherein the addressed first memory cells are coupled to said first bit line between a selected pass transistor and said first sense amp, and wherein the addressed second memory cells are coupled to said second bit line between a selected pass transistor and said second sense amp.

4. The memory of Claim 1, wherein said first and second pluralities of memory cells are grouped into segments, and wherein each segment is coupled to a bit line through a segment select gate, whereby each of said memory cells is coupled to said first and second bit lines through a segment select gate.

5. The memory of Claim 1, further comprising:
third and fourth bit lines coupled to said second sense amp opposite said first and second bit lines;
a third sense amp coupled to said third and fourth bit lines at the ends opposite said second sense amp;
means for causing said first and second sense amps to read data from said first and second bitlines, wherein said second sense amp reads no data from said third or fourth bit lines; and

means for causing said second and third sense amps to read data from said third and fourth bit lines, wherein said second sense amp reads no data from said first or second bit lines.

6. A random access memory layout scheme, comprising:

a plurality of sense amps alternating with a plurality of bit line pairs, wherein each sense amp is coupled to both bit lines of two of said bit line pairs;

each bit line of said pairs having a plurality of sections, wherein said bit lines can be electrically broken between the sections, and further having a plurality of segments selectively coupleable to said bit lines, and further having a plurality of memory cells coupled to each of the segments, and further having a plurality of word lines which each address a memory cell from each bit line of a bit line pair.

1 / 3

(PRIOR ART)

Fig. 1

Fig. 2

Fig. 3

*Fig. 4*

*Fig.6*

Fig.5